# EUROPEAN PATENT SPECIFICATION

(11) **EP 3 950 763 B1**
(45) Date of publication and mention of the grant of the patent: **22.10.2025**
(21) Application number: 19921581.5
(22) Date of filing: 17.12.2019
(51) Int. Cl.: C08G 59/56, C08L 63/00, B32B 15/092, C08K 3/013, H05K 1/03, H05K 1/05, C08G 59/68, C08G 59/70, C08G 59/72

(54) **THERMOSETTING EPOXY RESIN COMPOSITION, LAYERED SHEET FOR CIRCUIT BOARD, METAL-BASED CIRCUIT BOARD, AND POWER MODULE**
WÄRMEHÄRTENDE EPOXIDHARZZUSAMMENSETZUNG, SCHICHTPLATTE FÜR EINE LEITERPLATTE, METALLBASIERTE LEITERPLATTE UND LEISTUNGSMODUL
COMPOSITION DE RÉSINE ÉPOXY THERMODURCISSABLE, FEUILLE STRATIFIÉE DESTINÉE À UNE CARTE DE CIRCUIT IMPRIMÉ, CARTE DE CIRCUIT IMPRIMÉ À BASE DE MÉTAL ET MODULE DE COURANT

(30) Priority: 27.03.2019 JP 2019060226
(43) Date of publication of application: 09.02.2022
(73) Proprietor: NHK Spring Co., Ltd., Yokohama-shi, Kanagawa 236-0004 (JP)
(72) Inventor: MIZUNO, Katsumi, Yokohama-shi, Kanagawa 236-0004 (JP); KAWASAKI, Asuka, Yokohama-shi, Kanagawa 236-0004 (JP)
(74) Representative: AWA Sweden AB
(86) International application number: PCT/JP2019/049473
(87) International publication number: WO 2020/194920

(56) References cited:
- EP-A1- 2 871 918
- EP-A1- 3 378 897
- EP-A1- 3 401 346
- WO-A1-2016/093248
- JP-A- 2011 157 505
- JP-A- 2012 180 511
- JP-A- 2013 035 925
- JP-A- 2013 035 925
- JP-A- 2013 234 313
- JP-A- 2017 066 218
- JP-A- 2017 071 704
- JP-A- 2018 188 578
- JP-A- 2019 172 738
- JP-A- H07 216 055

## Description

### FIELD

The present invention relates to a thermosetting epoxy resin composition, a circuit board laminate, a metal-based circuit board, and a power module.

### BACKGROUND

The progress of electronics technology in recent years has been remarkable, with electrical and electronic equipment continuing to become rapidly more sophisticated and smaller. Hence, metal-based circuit boards capable of high-density mounting used for them have been developed to be smaller and to have a higher density than ever before. Accordingly, various performance improvements are also required for metal-based circuit boards, and a wide range of efforts have been made to meet these demands.

As a resin composition used for an insulating layer constituting a metal-based circuit board, a thermosetting resin composition using an epoxy resin has been widely used. As a curing agent for an epoxy resin, an aromatic diamine compound may be used. The aromatic diamine is known as a curing agent providing a cured product having a high glass transition temperature, but has disadvantages in which it is generally inferior to other curing agents in curability and has a long curing time under conditions of a curing temperature of 80 to 250°C.

Patent Literature 1 discloses the technique of a combined use of a phenol novolac resin as a curing agent and tris(4-methylphenyl)phosphine-triphenylborane as a curing accelerator in order to improve curability of a thermosetting epoxy resin composition and shorten a curing time.

Patent Literature 2 points to the problem in which, although curability improves, storage stability deteriorates, when tris(4-methylphenyl)phosphine-triphenylborane is added as a curing accelerator as in Patent Literature 1 in order to improve curability of a thermosetting epoxy resin composition using an aromatic diamine compound represented by the following formulae as a curing agent, i.e., methylenebis(2-ethyl6-methylaniline), methylenebis(2,6-diethylaniline), 4,4'-diaminodiphenylether, 9,9-bis(4-aminophenyl)fluorene, or the like. To solve this problem, this literature discloses the technique of further adding triphenylphosphine as a stabilizer.

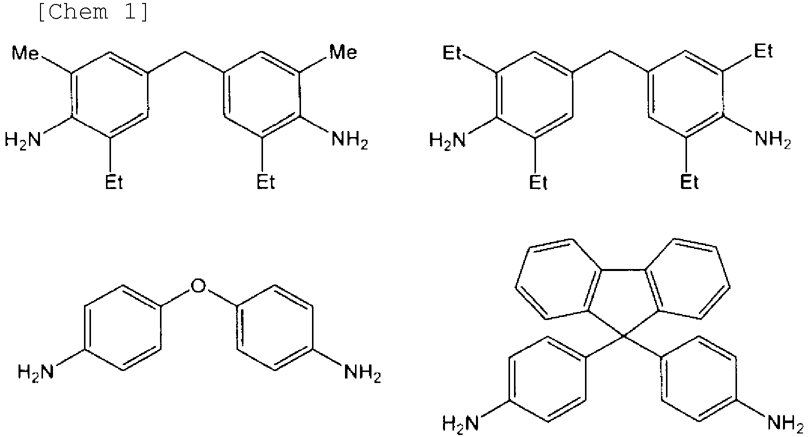

### CITATION LIST

### Patent Literature

[Patent Literature 1] Jpn. Pat. Appln. KOKAI Publication No. 2006-290946
[Patent Literature 2] Japanese Patent No. 5327087

### SUMMARY

### TECHNICAL PROBLEM

As the curing agent of the epoxy resin, the present inventors have found through intensive studies that the technique described in Patent Document 2 of adding tris(4-methylphenyl)phosphine-triphenylborane as a curing accelerator and a triphenylphosphine compound as a stabilizer to the epoxy resin composition containing the aromatic diamine compound shown above tends to improve curability of the epoxy resin composition and also tends to suppress deterioration of storage stability.

However, curability has not been improved to a level required for an insulating layer constituting a metal-based circuit board used in electrical and electronic equipment, and the reality is that a thermosetting epoxy resin composition capable of providing an insulating cured film satisfying all of voltage resistance, adhesiveness, and heat resistance required for the insulating layer in a short curing time has not been obtained.

An object of the present invention is to provide a thermosetting epoxy resin composition capable of forming a cured film excellent in all of voltage resistance, adhesiveness, and heat resistance in a short curing time. In addition, an object of the present invention is to provide a circuit board laminate, a metal-based circuit board, and a power module, excellent in all of voltage resistance, adhesiveness, and heat resistance in a short curing time.

### SOLUTION TO PROBLEM

According to one aspect of the present invention, there is provided a thermosetting epoxy resin composition that contains an epoxy resin, an aromatic amine compound represented by the following general formula (1), a boron-phosphorus complex represented by the following general formula (2), and a phosphorus compound represented by the following general formula (3).

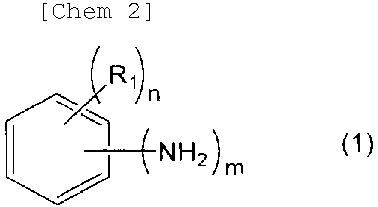

In general formula (1), R₁ represents an alkyl group, m represents an integer of 2 or more, n represents an integer of 0 or more, and m and n satisfy m + n ≤ 6, and when n is an integer of 2 or more, a plurality of R₁ may be the same as or different from each other.

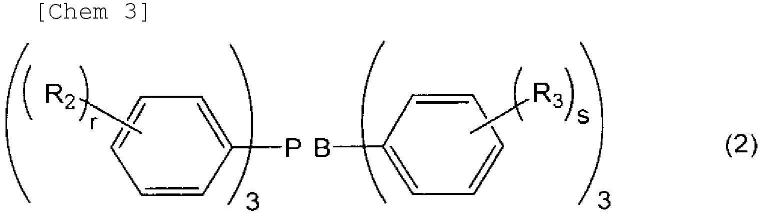

In general formula (2), R₂ and R₃ each independently represent an alkyl group, r represents an integer of 0 or more and 5 or less, and s represents an integer of 0 or more and 5 or less, when r is an integer of 2 or more, a plurality of R₂ may be the same as or different from each other, and when s is an integer of 2 or more, a plurality of R₃ may be the same as or different from each other.

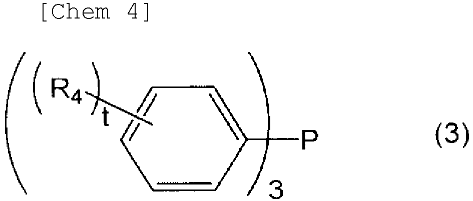

In general formula (3), R₄ represents an alkyl group or an alkoxy group, and t represents an integer of 0 or more and 5 or less, and when t is an integer of 2 or more, a plurality of R₄ may be the same as or different from each other.

In one embodiment of the present invention, the thermosetting epoxy resin composition may further contain an inorganic filler.

According to another aspect of the present invention, there is provided a circuit board laminate that includes a metal substrate, an insulating layer provided on at least one surface of the metal substrate, and a metal foil provided on the insulating layer, in which the insulating layer is a cured film of a thermosetting epoxy resin composition that contains an epoxy resin and an aromatic amine compound represented by the following general formula (1).

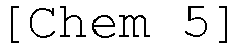

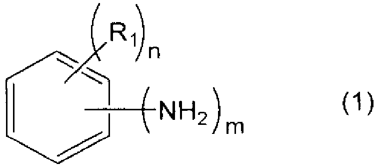

In general formula (1), R₁ represents an alkyl group, m represents an integer of 2 or more, n represents an integer of 0 or more, and m and n satisfy m + n ≤ 6, and when n is an integer of 2 or more, a plurality of R₁ may be the same as or different from each other.

The thermosetting epoxy resin composition constituting the insulating layer further contain a boron-phosphorus complex represented by the following general formula (2), and a phosphorus compound represented by the following general formula (3).

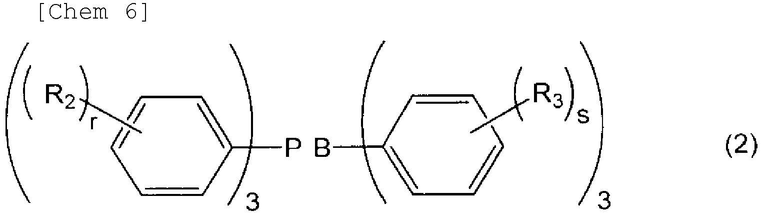

In general formula (2), R₂ and R₃ each independently represent an alkyl group, r represents an integer of 0 or more and 5 or less, and s represents an integer of 0 or more and 5 or less, when r is an integer of 2 or more, a plurality of R₂ may be the same as or different from each other, and when s is an integer of 2 or more, a plurality of R₃ may be the same as or different from each other.

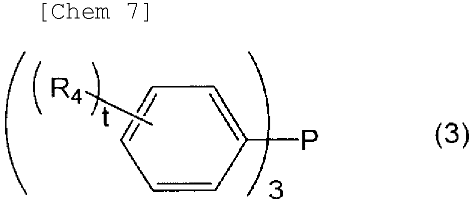

In general formula (3), R₄ represents an alkyl group or an alkoxy group, and t represents an integer of 0 or more and 5 or less, and when t is an integer of 2 or more, a plurality of R₄ may be the same as or different from each other.

In another embodiment of the present invention, the thermosetting epoxy resin composition constituting the insulating layer may further contain an inorganic filler.

According to another aspect of the present invention, there is provided a metal-based circuit board formed by patterning the metal foil included in the circuit board laminate.

According to another aspect of the present invention, there is provided a power module including the metal-based circuit board.

### ADVANTAGEOUS EFFECTS OF INVENTION

According to the present invention, it is possible to provide a thermosetting epoxy resin composition capable of forming a cured film excellent in all of voltage resistance, adhesiveness, and heat resistance in a short curing time. In addition, according to the present invention, it is possible to provide a circuit board laminate, a metal-based circuit board, and a power module, excellent in all of voltage resistance, adhesiveness, and heat resistance in a short curing time.

### BRIEF DESCRIPTION OF THE DRAWINGS

FIG. 1 is a perspective view schematically showing a circuit board laminate according to an embodiment;
FIG. 2 is a cross-sectional view taken along line II-II of the circuit board laminate shown in FIG. 1;
FIG. 3 is a cross-sectional view schematically showing an example of a circuit board obtained from the circuit board laminate shown in FIGS. 1 and 2; and
FIG. 4 is a cross-sectional view schematically showing a power module according to an embodiment.

### DETAILED DESCRIPTION

Hereinafter, the present embodiment will be described.

A thermosetting epoxy resin composition according to an embodiment of the present invention (hereinafter, also referred to as a "resin composition according to the present embodiment" and the like) contains at least an epoxy resin and a curing agent, and as the curing agent, an aromatic amine compound represented by general formula (1) described later.

In one embodiment, the resin composition according to the present embodiment further contains a catalyst. As this catalyst, at least a curing accelerator is contained. If a boron-phosphorus complex represented by general formula (2) described later is contained as a curing accelerator, it is preferable that a phosphorus compound represented by general formula (3) described later be contained as a stabilizer.

### <Epoxy Resin>

As the epoxy resin contained in the thermosetting epoxy resin according to the embodiment of the present invention, monomers, oligomers, and polymers in general having two or more epoxy groups in one molecule can be used regardless of the molecular weight and molecular structure thereof. Examples of such epoxy resins include bisphenol-type epoxy resins such as bisphenol A-type epoxy resins, bisphenol F-type epoxy resins, bisphenol E-type epoxy resins, bisphenol S-type epoxy resins, hydrogenated bisphenol A-type epoxy resins, bisphenol M-type epoxy resins (4,4'-(1,3-phenylenediisopridien)bisphenol-type epoxy resin), bisphenol P-type epoxy resins (4,4'-(1,4-phenylenediisopridien)bisphenol-type epoxy resin), and bisphenol Z-type epoxy resins (4,4'-cyclohexadiene bisphenol-type epoxy resin); novolac-type epoxy resins such as phenol novolac-type epoxy resins, brominated phenol novolac-type epoxy resins, cresol novolac-type epoxy resins, tetraphenol group ethane-type novolac-type epoxy resins, and novolac-type epoxy resins having a condensed ring aromatic hydrocarbon structure; biphenyl-type epoxy resins; aralkyl-type epoxy resins such as xylylene-type epoxy resins and biphenyl aralkyl-type epoxy resins; epoxy resins having naphthalene skeletons such as naphthylene ether-type epoxy resins, naphthol-type epoxy resins, naphthalene-type epoxy resins, naphthalene diol-type epoxy resins, bifunctional or tetrafunctional epoxy-type naphthalene resins, binaphthyl-type epoxy resins, and naphthalene aralkyl-type epoxy resins; anthracene-type epoxy resins; phenoxy-type epoxy resins; dicyclopentadiene-type epoxy resins; norbornene-type epoxy resins; adamantane-type epoxy resins; fluorene-type epoxy resins; phosphorus-containing epoxy resins; alicyclic epoxy resins; aliphatic chain epoxy resins; bisphenol A novolac-type epoxy resins; bixylenol-type epoxy resins; triphenol methane-type epoxy resins; trihydroxyphenylmethane-type epoxy resins; tetraphenylolethane-type epoxy resins; heterocyclic epoxy resins such as triglycidyl isocyanurate; glycidyl amines such as N,N,N',N'-tetraglycidylmetaxylenediamine, N,N,N',N'-tetraglycidylbisaminomethylcyclohexane, and N,N-diglycidylaniline; copolymers of glycidyl (meth)acrylate and an ethylenically unsaturated double bond-containing compound, epoxy resins having butadiene structures, diglycidyl etherified product of bisphenol, diglycidyl etherified product of naphthalenediol, and glycidyl etherified product of phenols. The resin composition according to the present embodiment can include one or two or more kinds selected from them as an epoxy resin.

### <Curing Agent>

The resin composition according to the present embodiment contains an aromatic amine compound represented by general formula (1) as a curing agent.

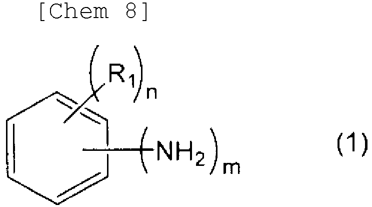

In general formula (1), R₁ represents an alkyl group, m represents an integer of 2 or more, n represents an integer of 0 or more, and m and n satisfy m + n ≤ 6. When n is an integer of 2 or more, a plurality of R₁ may be the same as or different from each other.

m representing the number of amino groups substituted onto the benzene ring is 2 or more and 6 or less, may be 2 or more and 5 or less, may be 2 or 3, and may be 2. When m is 2, two amino groups are positioned to the benzene ring in such a manner that one is meta-positioned or ortho-positioned with respect to the other.

R₁ is any substituent on the benzene ring. The number of carbon atoms of alkyl groups represented by R₁ may be 1 to 4, and may be 1 or 2. Specific examples of the alkyl group include a methyl group, an ethyl group, a propyl group, and a butyl group. n representing the number of R₁ substituted onto the benzene ring is 0 or more and 4 or less, may be 0 or more and 3 or less, and may be 1 or more and 3 or less.

Since the aromatic amine compound represented by general formula (1) has a small steric hindrance, the effect of improving curability is excellent, and sufficient performance can be exhibited even in a short curing time.

Specific examples of the aromatic amine compound represented by general formula (1) include diethyltoluenediamine represented by the following formula: 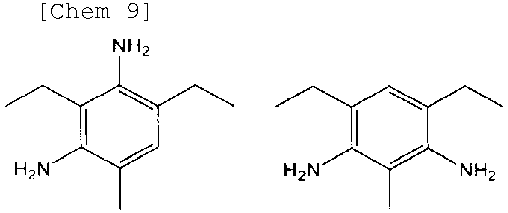 1,2-phenylenediamine, 1,3-phenylenediamine, 2,4-diaminotoluene, 2,6-diaminotoluene, 2,3-diaminotoluene, 3,4-diaminotoluene, 2,4,6-trimethyl-1, 3-phenylenediamine, 1,2,4-triaminobenzene, 4,5-dimethyl-1,2-phenylenediamine, 1,4-phenylenediamine, and 2,3,5,6-tetramethyl-1,4-phenylenediamine.

The aromatic amine compound represented by general formula (1) may be used alone or in combination of two or more kinds. Production of these aromatic amine compounds is not particularly limited, and a commercially available product can be used.

In the resin composition according to the present embodiment, a preferred blending ratio of the aromatic amine compound represented by general formula (1) may be, for example, 5 to 50 parts by mass, or 10 to 40 parts by mass, with respect to 100 parts by mass of the epoxy resin.

### <Curing Accelerator>

The resin composition according to the present embodiment may contain a boron-phosphorus complex represented by general formula (2) as a curing accelerator.

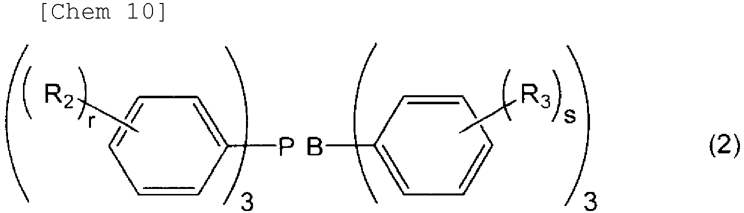

In general formula (2), R₂ and R₃ each independently represent an alkyl group, r represents an integer of 0 or more and 5 or less, and s represents an integer of 0 or more and 5 or less. When r is an integer of 2 or more, a plurality of R₂ may be the same as or different from each other. When s is an integer of 2 or more, a plurality of R₃ may be the same as or different from each other.

R₂ and R₃ are any substituents on the benzene ring. Specific examples of the alkyl groups represented by R₂ and R₃ include a methyl group and ethyl group.

r representing the number of R₂ substituted onto the benzene ring onto which the P atom is substituted is 0 or more and 5 or less, may be 0 or more and 3 or less, may be 0 or more and 2 or less, and may be 0 or 1. When r is 1, the alkyl group represented by R₂ may be positioned at any of an ortho position, meta position or para position with respect to the P atom.

s representing the number of R₃ substituted onto the benzene ring onto which the B atom is substituted is 0 or more and 5 or less, may be 0 or more and 3 or less, may be 0 or more and 2 or less, and may be 0.

Specific examples of the boron-phosphorus complex represented by general formula (2) include triphenylphosphine triphenylborane (TPP-S) and trisparamethylphenylphosphine triphenylborane (TPTP-S) represented by the following formulae. In TPTP-S, the methyl group may be positioned at any of an ortho position, meta position or para position with respect to the P atom.

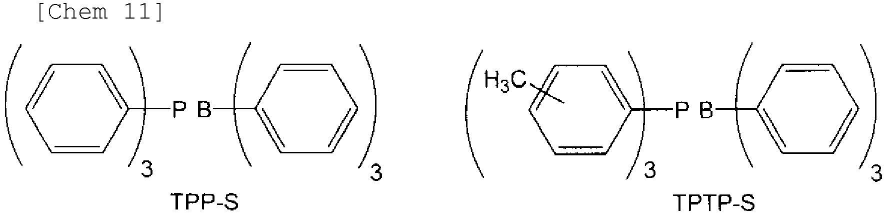

In one embodiment, the resin composition according to the present embodiment preferably contains TPP-S and/or TPTP-S as a curing accelerator.

The boron-phosphorus complex represented by general formula (2) may be used alone or in combination of two or more kinds. Production of the boron-phosphorus complex represented by general formula (2) is not particularly limited, and a commercially available product can be used.

In the resin composition according to the present embodiment, a preferred content of the boron-phosphorus complex represented by general formula (2) may be, for example, 0.01 to 5 parts by mass, or 0.1 to 5 parts by mass, with respect to 100 parts by mass of the epoxy resin.

### <Stabilizer>

If the resin composition according to the present embodiment contains the boron-phosphorus complex represented by general formula (2) described above as a curing accelerator, it is preferable that a phosphorus compound represented by the following general formula (3) be contained as a stabilizer.

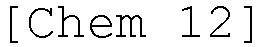

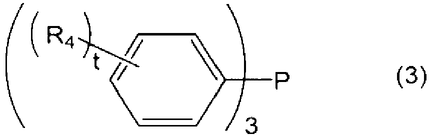

In general formula (3), R₄ represents an alkyl group or an alkoxy group, and t represents an integer of 0 or more and 5 or less. When t is an integer of 2 or more, a plurality of R₄ may be the same as or different from each other.

R₄ is any substituent on the benzene ring. Specific examples of the alkyl group represented by R₄ include a methyl group, an ethyl group, and a propyl group. Specific examples of the alkoxy group represented by R₄ include a methoxy group and a butoxy group.

t representing the number of R₄ substituted onto the benzene ring is 0 or more and 5 or less, may be 0 or more and 4 or less, may be 0 or more and 2 or less, and may be 0.

Specific examples of the phosphorus compound represented by general formula (3) include triphenylphosphine (TPP) represented by the following formula.

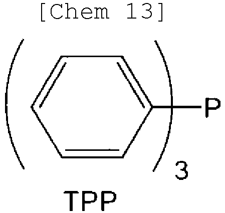

The phosphorus compound represented by general formula (3) may be used alone or in combination of two or more kinds. Production of the phosphorus compound represented by the formula (3) is not particularly limited, and a commercially available product can be used.

When the resin composition according to the present embodiment contains the aromatic amine compound represented by general formula (1) as a curing agent, the boron-phosphorus complex represented by general formula (2) as a curing accelerator, and the phosphorus compound represented by general formula (3) as a stabilizer, all of voltage resistance, adhesiveness, and heat resistance of a cured film obtained in a short curing time greatly improve. The reason for this is not necessarily clear, but is presumed as follows. That is, it is presumed that as the curing reaction of the resin does not progress at a normal temperature and a rapid curing reaction occurs only when the resin is heated, the molecular weight can be sufficiently increased in a short time during the drying step, and as control is easy, an appropriate melting viscosity can be provided during pressing.

In the resin composition according to the present embodiment, a preferred blending ratio of the phosphorus compound represented by general formula (3) may be 0.01 to 5 parts by mass, or 0.05 to 5 parts by mass, with respect to 100 parts by mass of the epoxy resin.

In determining the blending amount of the stabilizer, it is preferable to consider the blending amount of the curing accelerator described above. In one embodiment, [total mass of phosphorus compound represented by general formula (3) / total mass of boron-phosphorus complex represented by general formula (2)] is preferably in a range of 0.002 to 5, and more preferably in a range of 0.1 or more and less than 1.

In determining the blending amount of the stabilizer, it is also preferable to consider the total amount of the blending amount of the curing accelerator with respect to the blending amount of the epoxy resin. In one embodiment, the total mass of the phosphorus compound represented by general formula (3) and the boron-phosphorus complex represented by general formula (2) is preferably 0.5 to 30 parts by mass, and more preferably 1 to 10 parts by mass, with respect to 100 parts by mass of the epoxy resin.

### <Inorganic Filler>

The resin composition according to the present embodiment may further contain an inorganic filler in addition to the components described above. As the inorganic filler, those having excellent electrical insulation properties and high thermal conductivity are preferable, and examples of the inorganic fillers include alumina, silica, aluminum nitride, boron nitride, silicon nitride, and magnesium oxide. It is preferable to use one, or two or more kinds selected from them.

The content ratio of the inorganic filler in the resin composition can be appropriately set according to the use of the resin composition, the type of the inorganic filler, and the like. For example, it may be 20 to 85% by volume or 40 to 80% by volume based on the total volume of the epoxy resin.

### <Other Additives>

The resin composition according to the present embodiment may contain an additive as necessary in addition to the above-described components. Examples of the additive include a reactive diluent, solvent, thermoplastic resin, rubber, and elastomer.

### <Circuit Board Laminate>

A circuit board laminate according to the present embodiment includes a metal substrate, an insulating layer provided on at least one surface of the metal substrate, and a metal foil provided on the insulating layer, and the insulating layer is a cured film of the resin composition described above.

Hereinafter, a circuit board laminate according to the present embodiment will be described in detail with reference to the drawings. Elements having the same or similar functions are denoted by the same reference numerals, and redundant description will be omitted.

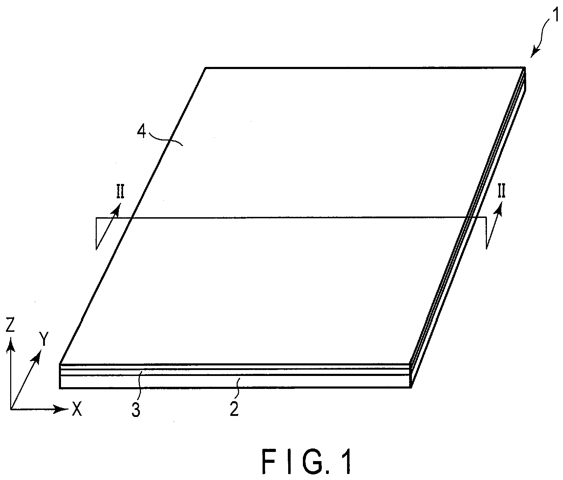

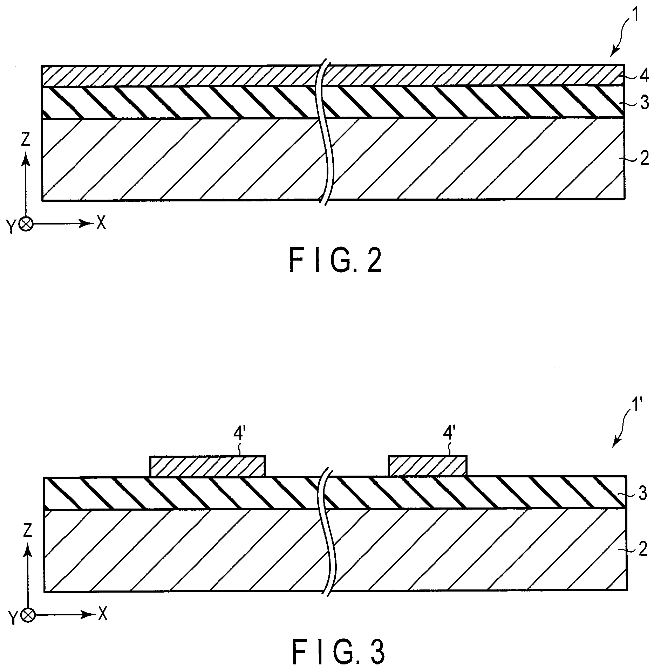

A circuit board laminate 1 shown in FIGS. 1 and 2 has a three-layer structure in which an insulating layer 3 is formed on one surface of a metal substrate 2, and a metal foil 4 is formed on the insulating layer 3. In another embodiment of the present invention, a five-layer structure may be employed in which the insulating layers 3 are formed on both surfaces of the metal plate 2, and the metal foil 4 is formed on each insulating layer 3. In FIGS. 1 and 2, X and Y directions are parallel to the main surface of the metal substrate 2 and orthogonal to each other, and a Z direction is a thickness direction perpendicular to the X and Y directions. While FIG. 1 shows a rectangular circuit board laminate 1 as an example, the circuit board laminate 1 may have other shapes.

The insulating layer 3 is formed of a cured film of the resin composition described above. That is, in one embodiment, the insulating layer 3 contains an epoxy resin and a curing agent, and as the curing agent, contains at least an aromatic amine compound represented by general formula (1) described above. In another embodiment, the insulating layer 3 further contains a catalyst, and as the catalyst, contains at least a curing accelerator. If the boron-phosphorus complex represented by general formula (2) described above is contained as a curing accelerator, it is preferable that the phosphorus compound represented by general formula (3) described above be contained as a stabilizer. Each of the components contained in the insulating layer 3, the blending ratio of the components, and the like are as described above for the resin composition.

The metal substrate 2 is made of, for example, a single metal or an alloy. As a material of the metal substrate 2, for example, aluminum, iron, copper, an aluminum alloy, a copper alloy, or stainless steel can be used. The metal substrate 2 may further include a non-metal such as carbon. For example, the metal substrate 2 may include aluminum combined with carbon. The metal substrate 2 may have a single-layer or multi-layer structure.

The metal substrate 2 has a high thermal conductivity. Typically, the metal substrate 2 has a thermal conductivity of 60W ·m⁻¹ ·K⁻¹ or more.

The metal substrate 2 may or may not have flexibility. The metal substrate 2 has a thickness in a range of, for example, 0.2 to 5 mm.

The metal foil 4 is provided on the insulating layer 3. The metal foil 4 faces the metal substrate 2 with the insulating layer 3 interposed therebetween.

The metal foil 4 is made of, for example, a single metal or an alloy. As a material of the metal foil 4, for example, copper or aluminum can be used. The metal foil 4 has a thickness in a range of, for example, 10 to 2000 µm.

Since the insulating layer 3 contains the thermally conductive composite particles, the circuit board laminate 1 has excellent thermal conductivity.

The circuit board laminate 1 is manufactured by, for example, the following method.

First, the above-described insulating resin composition is applied to at least one of the metal substrate 2 or the metal foil 4. For application of the insulating resin composition, for example, a roll coating method, a bar coating method, or a screen printing method can be used. The application method may be a continuous method or a single plate method.

After the coating film is dried as necessary, the metal substrate 2 and the metal foil 4 are superposed so as to face each other with the coating film interposed therebetween. Further, they are heat-pressed. In this manner, the circuit board laminate 1 is obtained.

In this method, the coating film is formed by applying the insulating resin composition to at least one of the metal plate 2 or the metal foil 4; however, in another embodiment, the coating film may be formed in advance by applying the insulating resin composition to a base material such as a PET film and drying, and thermally transferring this to one of the metal substrate 2 or the metal foil 4.

### <Metal-based circuit board>

The metal-based circuit board according to the present embodiment includes a metal substrate, an insulating layer provided on at least one surface of the metal substrate, and a metal pattern provided on the insulating layer, and it is characterized by the insulating layer containing the thermally conductive composite particles.

Hereinafter, the metal-based circuit board according to the present embodiment will be described in detail with reference to the drawings.

A metal-based circuit board 1' shown in FIG. 3 is obtainable from the circuit board laminate shown in FIGS. 1 and 2, and includes the metal substrate 2, the insulating layer 3, and a circuit pattern 4'. The circuit pattern 4' is obtainable by patterning the metal foil 4 of the circuit board laminate described with reference to FIGS. 1 and 2. This patterning is obtainable by, for example, forming a mask pattern on the metal foil 4, and removing an exposed portion of the metal foil 4 by etching. The metal-based circuit board 1' is obtainable by, for example, performing the above-described patterning on the metal foil 4 of the circuit board laminate 1 described earlier, and, as necessary, performing processing such as cutting and drilling processing.

The metal-based circuit board 1' includes the thermally conductive composite particles in the insulating layer 3, and therefore has excellent thermal conductivity.

The power module according to the present embodiment includes the above-described metal-based circuit board.

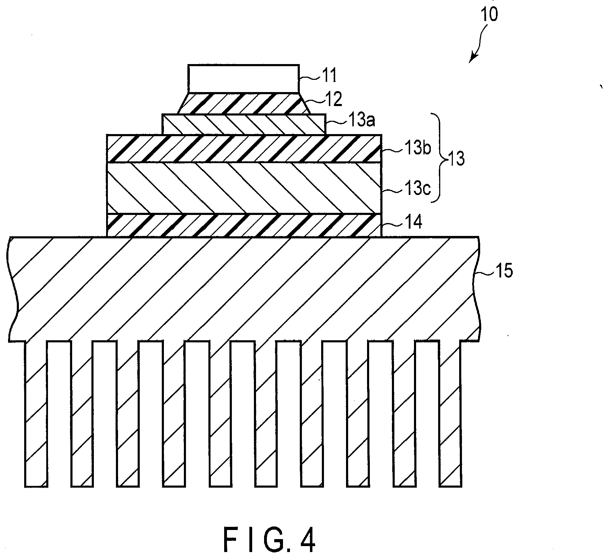

FIG. 4 shows an example of the power module according to the present embodiment. The power module 10 shown in FIG. 4 includes a heat sink 15, a heat dissipation sheet 14, a metal-based circuit board 13, a solder layer 12, and a power device 11, laminated in this order. The metal-based circuit board 13 included in the power module 10 is formed by laminating a metal substrate 13c, an insulating layer 13b, and a circuit pattern 13a in this order. Since the insulating layer 13b includes the thermally conductive composite particles, the power module 10 has excellent thermal conductivity.

Examples

Hereinafter, the present embodiment will be described in a concrete manner with examples.

### [Experiment Example A]

### <Preparation of Epoxy Resin Composition>

### (Preparation of Resin Composition 1)

28 parts by mass of the curing agent (1) ("DETDA-80"; manufactured by Lonza) represented by the following formula as a curing agent, 0.8 parts by mass of triphenylphosphine triphenylborate TPP-S (trade name "TPP-S"; manufactured by HOKKO CHEMICAL INDUSTRY CO., LTD.) represented by the following formula as a curing accelerator, and 0.3 parts by mass of triphenylphosphine TPP (trade name "TPP"; manufactured by HOKKO CHEMICAL INDUSTRY CO., LTD.) represented by the following formula as a stabilizer were added to 100 parts by mass of bisphenol A-type epoxy resin (hereinafter also referred to as "BA-type epoxy resin")) (trade name EXA-850CRP; manufactured by DIC Corporation). The mixture was stirred with a planetary stirrer at room temperature until it became homogeneous, and then methyl ethyl ketone was added as a solvent to form a solution.

In the obtained resin solution, a mixture of alumina (Al₂O₃) (trade name AS40; manufactured by Showa Denko K.K.), aggregates of boron nitride (BN) (trade name HP40; manufactured by Mizushima Ferroalloy Co., Ltd.), and fine powder of boron nitride (BN) (trade name NX1; manufactured by Momentive Performance Materials Inc.) at 18:9:1 (mass ratio) was dispersed as a filler (inorganic filler) so as to be 65% by volume with respect to the total volume of the BA-type epoxy resin, thereby obtaining an epoxy-resin composition 1 (Table 1).

The numerical values in Table 1 represent parts by mass.
- Curing agent (1): diethyltoluenediamine represented by the following formula (trade name DETDA-80; manufactured by Lonza) 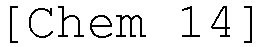 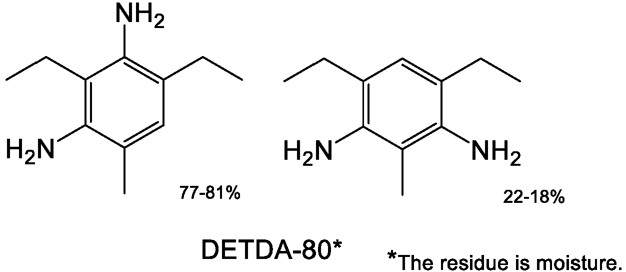
- Curing accelerator (trade name TPP-S; manufactured by HOKKO CHEMICAL INDUSTRY CO., LTD.) 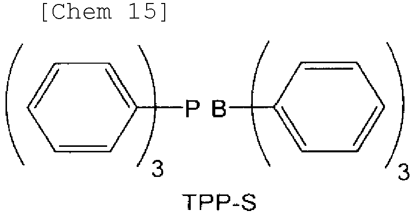
- Stabilizer (trade name TPP; manufactured by HOKKO CHEMICAL INDUSTRY CO., LTD.)

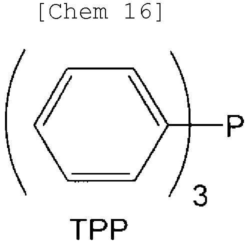

### (Preparation of Resin Compositions 2 to 8)

Resin compositions 2 to 8 were prepared under the same conditions and by the same method as those of the resin composition 1 except that the curing agent (1) was changed to the aromatic amine compound shown in Table 1 with respect to the resin composition 1 (Table 1).

### <Production of Laminate>

Each of the resin compositions prepared above was applied to a PET film and dried at 80°C for 80 minutes to form a coating film. The resulting coating film on the PET film was thermally transferred onto an aluminum plate (aluminum base) under the conditions of 100°C/20 MPa/10 seconds in a vacuum. Next, a circuit copper foil was bonded onto the coating film on the aluminum base under the conditions of 100°C/2.5 Mpa/10 seconds in a vacuum. Next, the insulating layer was subjected to the main curing under the conditions of 160°C/1 hour and 30 minutes with no load in an annealing oven to obtain a laminate having a layer structure of aluminum base/insulating layer (thickness of 130 µm)/copper foil.

### <Evaluation Method>

### (Withstand Voltage)

An AC voltage is applied in insulating oil between a circuit pattern of φ20 mm and a copperplate on the back surface to measure a withstand voltage. While repeating the operation of increasing the voltage from the start voltage by 500 V and applying each voltage for 20 seconds, the voltage is increased stepwise to measure a breakdown voltage. The measurement results are shown in Table **1.**

### (Peel Strength)

The copper foil of the circuit board laminate cut into a predetermined size was partially removed by etching to form a copper-foil pattern having a width of 10 **mm.** One end of the copper-foil pattern was grasped, and the copper-foil pattern was peeled off from the metal substrate at a rate of 50 mm/min while applying force so that the peeled off portion of the copper-foil pattern was perpendicular to the main surface of the metal substrate. At this time, the force applied to the copper-foil pattern was defined as a peel strength. The higher the peel strength, the better the adhesiveness. The measurement results are shown in Table **1.**

### (Glass Transition Temperature (Tg))

Measurement was carried out by dynamic mechanical analysis (DMA), and the peak temperature of tan δ was defined as a glass transition temperature (Tg/°C). The higher the glass transition temperature, the better the heat resistance. The measurement results are shown in Table 1.

### (Thermal Conductivity)

The obtained insulating layer was processed into a size of 10 mm × 10 mm to obtain a sample. The thermal conductivity was calculated by multiplying all of the thermal diffusivity, specific gravity, and specific heat of the sample. The measurement results are shown in Table 1.

A xenon-flash analyzer (LFA467 HyperFlash (registered trademark) manufactured by NETZSCH) was used as a measuring apparatus. The thermal diffusivity was obtained by the laser flash method. The specific gravity was obtained using the Archimedes method. The specific heat was obtained by raising the temperature from room temperature to 700°C at a temperature increasing rate of 10°C/min in a nitrogen atmosphere, using the differential scanning calorimeter ("Q2000", manufactured by TA Instruments).

### [TABLE 1]

**Table 1**

| | | Ex 1 | Ex 2 | Ex 3 | Ex 4 | Ex 5 | Ex 6 | Ex 7 | Ex 8 |
|---|---|---|---|---|---|---|---|---|---|
| | | Resin Comp. 1 | Resin Comp. 2 | Resin Comp. 3 | Resin Comp. 4 | Resin Comp. 5 | Resin Comp. 6 | Resin Comp. 7 | Resin Comp. 8 |
| Epoxy Resin | | 100 | 100 | 100 | 100 | 100 | 100 | 100 | 100 |
| Curing Agent | (1) DETDA | 28 | | | | | - | - | - |
| | (2) 2,6-DAT | | 18 | | | | | | |
| | (3) 3,4-DAT | | | 18 | | | | | |
| | (4) 1,3-PDA | | | | 16 | | | | |
| | (5) 2,4-DAT | | | | | 18 | | | |
| | (6) DDS | | | | | | 34 | - | - |
| | (7) M-DEA | | | | | | | 44 | |
| | (8) M-DIPA | | | | | | | | 47 |
| Curing Accelerator | TPP-S | 0.8 | 0.8 | 0.8 | 0.8 | 0.8 | 0.8 | 0.8 | 0.8 |
| Stabilizer | TPP | 0.3 | 0.3 | 0.3 | 0.3 | 0.3 | 0.3 | 0.3 | 0.3 |
| Evaluation | Withstand Voltage [kV] | 9.0 | 7.8 | 7.5 | 6.7 | 6.9 | 1.6 | 5.3 | 5.9 |
| | Peel [N/cm] | 8.3 | 11.4 | 11.9 | 11.5 | 10.6 | 1.8 | 9.3 | 7.8 |
| | Thermal Conductivity [W/mk] | 8.2 | 8.5 | 7.9 | 7.2 | 7.7 | 8.0 | 7.8 | 6.9 |

The details of each of the components shown in Table 1 are as follows.
- Epoxy resin: Bisphenol A-type epoxy resin (epoxy 173 equivalents g/mol) (trade name EXA-850CRP; manufactured by DIC Corporation)
- Curing agent (2): 2,6-diaminotoluene (2,6-DAT) (manufactured by Tokyo Chemical Industry Co., Ltd.) 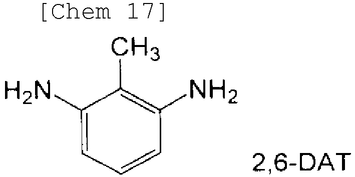
- Curing agent (3): 3,4-diaminotoluene (3,4-DAT) (manufactured by Tokyo Chemical Industry Co., Ltd.) 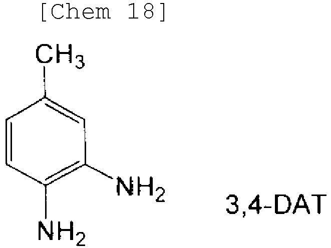
- Curing agent (4): 1,3-phenylenediamine (1,3-PDA) (manufactured by Tokyo Chemical Industry Co., Ltd.) 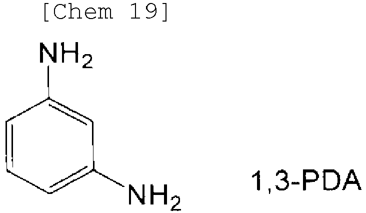
- Curing agent (5): 2,4-diaminotoluene (2,4-DAT) (manufactured by Tokyo Chemical Industry Co., Ltd.) 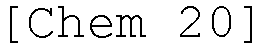 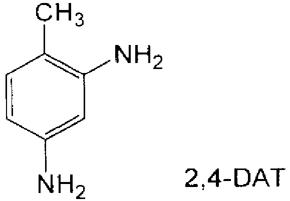
- Curing agent (6): 4,4'-diaminodiphenyl sulfone (DDS) represented by the following formula (trade name SEIKACURE S; manufactured by Seika Corporation) 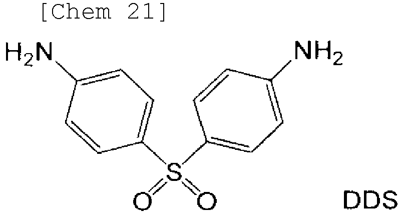
- Curing agent (7): 4,4'-methylenebis(2,6-diethylaniline) represented by the following formula (trade name M-DEA; manufactured by Lonza) 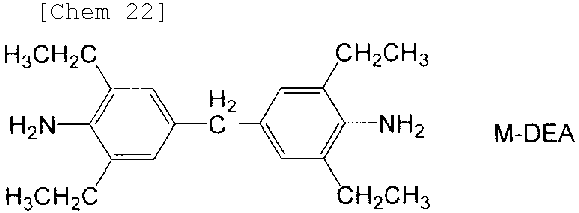
- Curing agent (8): 4,4'-methylenebis(2,6-diisopropylaniline) represented by the following formula (trade name M-DIPA; manufactured by Lonza)

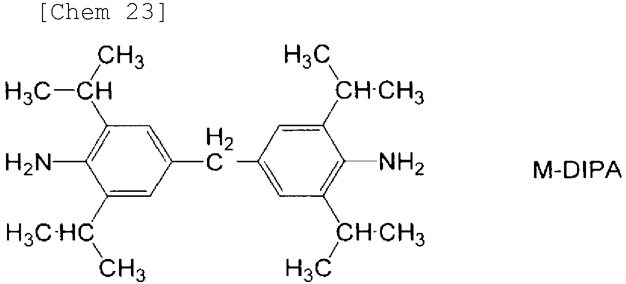

The results of Table 1 show that by using the thermosetting epoxy resin composition according to the embodiment of the present invention, it is possible to provide a circuit board laminate excellent in all of voltage resistance, adhesiveness, and heat resistance in a short curing time.

### [Experiment Example B]

### <Preparation of Epoxy Resin Composition>

### (Preparation of Resin Composition 101)

A resin composition 101 was prepared under the same conditions and by the same method as the resin composition 1 except that the curing accelerator and the stabilizer were not used with respect to preparation of the resin composition 1 (Table 2).

### (Preparation of Resin Compositions 102 to 104)

Resin compositions 102 to 104 were prepared under the same conditions and by the same method as those of the resin composition 101 except that the curing agent (1) was changed to the aromatic amine compound shown in Table 2 with respect to the resin composition 101 (Table 2).

### <Production of Laminate>

A laminate having a layer structure of aluminum base/insulating layer (thickness of 130 µm)/copper foil was obtained under the same conditions/method as in Experiment Example A. The obtained laminate was evaluated for the withstand voltage, peel strength, and thermal conductivity, by the same evaluation method as in Experiment Example A. The results are shown in Table 2.

### [TABLE 2]

**Table 2**

| | | Ex 101 | Ex102 | Ex 103 | Ex 104 |
|---|---|---|---|---|---|
| | | Resin Comp. 101 | Resin Comp. 102 | Resin Comp. 103 | Resin Comp. 104 |
| Epoxy Resin | | 100 | 100 | 100 | 100 |
| Curing Agent | (1) DETDA | 28 | | | |
| | (6) DDS | | 34 | | |
| | (7) M-DEA | | | 44 | |
| | (8) M-DIPA | | | | 47 |
| Curing Accelerator | | - | - | - | - |
| Stabilizer | | - | - | - | - |
| Evaluation | Withstand Voltage [kV] | 8.1 | 3.2 | 0.0 | 1.6 |
| | Peel [N/cm] | 8.0 | 8.7 | 0.0 | 9.0 |
| | Thermal Conductivity [W/mk] | 7.3 | 7.0 | 7.3 | 6.3 |

The results of Table 2 show that the circuit board laminate according to the embodiment of the present invention has excellent performance in all of voltage resistance, adhesiveness, and heat resistance in a short curing time.

### REFERENCE SIGNS LIST

- 1: circuit board laminate
- 1': metal-based circuit board
- 2: metal substrate
- 3: insulating layer
- 4: metal foil
- 4': circuit pattern
- 10: power module
- 11: power device
- 12: solder layer
- 13: metal-based circuit board
- 13a: circuit pattern
- 13b: insulating layer
- 13c: metal substrate
- 14: heat dissipation sheet
- 15: heat sink

## Claims

1. A thermosetting epoxy resin composition comprising an epoxy resin, an aromatic amine compound represented by general formula (1) below, a boron-phosphorus complex represented by general formula (2) below, and a phosphorus compound represented by general formula (3) below, 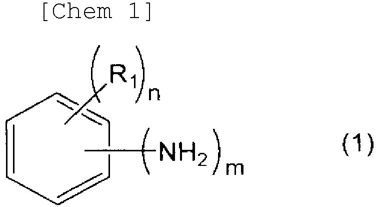
wherein in general formula (1), R₁ represents an alkyl group, m represents an integer of 2 or more, n represents an integer of 0 or more, and m and n satisfy m + n ≤ 6, and when n is an integer of 2 or more, a plurality of R₁ may be the same as or different from each other, 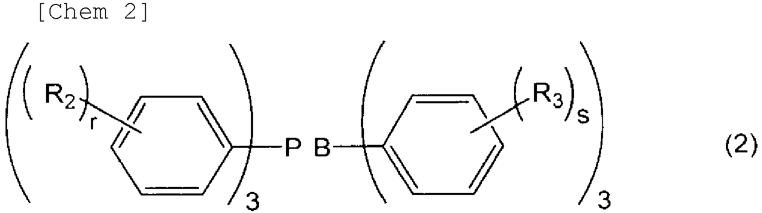
wherein in general formula (2), R₂ and R₃ each independently represent an alkyl group, r represents an integer of 0 or more and 5 or less, and s represents an integer of 0 or more and 5 or less, when r is an integer of 2 or more, a plurality of R₂ may be the same as or different from each other, and when s is an integer of 2 or more, a plurality of R₃ may be the same as or different from each other, 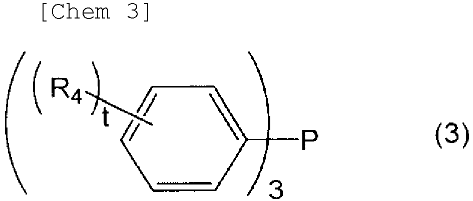
wherein in general formula (3), R₄ represents an alkyl group or an alkoxy group, and t represents an integer of 0 or more and 5 or less, and when t is an integer of 2 or more, a plurality of R₄ may be the same as or different from each other.

2. The thermosetting epoxy resin composition according to claim 1, further comprising an inorganic filler.

3. A circuit board laminate comprising: a metal substrate; an insulating layer provided on at least one surface of the metal substrate; and a metal foil provided on the insulating layer, the insulating layer being a cured film of a thermosetting epoxy resin composition comprising an epoxy resin and an aromatic amine compound represented by general formula (1) below, 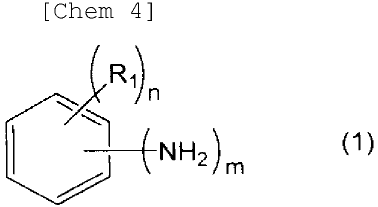
wherein in general formula (1), R₁ represents an alkyl group, m represents an integer of 2 or more, n represents an integer of 0 or more, and m and n satisfy m + n ≤ 6, and when n is an integer of 2 or more, a plurality of R₁ may be the same as or different from each other,
wherein the thermosetting epoxy resin composition further comprises a boron-phosphorus complex represented by general formula (2) below, and a phosphorus compound represented by general formula (3) below, 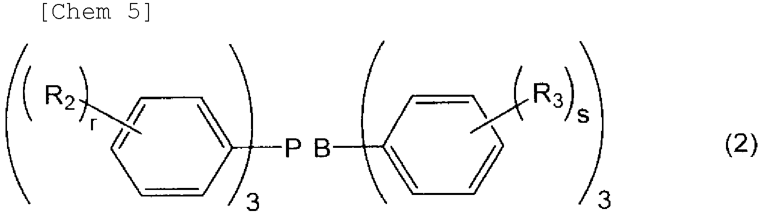
wherein in general formula (2), R₂ and R₃ each independently represent an alkyl group, r represents an integer of 0 or more and 5 or less, and s represents an integer of 0 or more and 5 or less, when r is an integer of 2 or more, a plurality of R₂ may be the same as or different from each other, and when s is an integer of 2 or more, a plurality of R₃ may be the same as or different from each other, 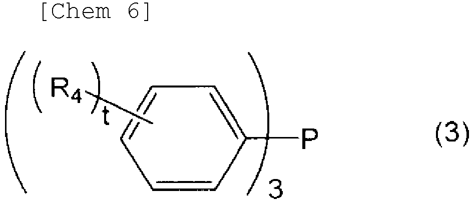
wherein in general formula (3), R₄ represents an alkyl group or an alkoxy group, and t represents an integer of 0 or more and 5 or less, and when t is an integer of 2 or more, a plurality of R₄ may be the same as or different from each other.

4. The circuit board laminate according to claim 3, wherein the thermosetting epoxy resin composition further comprises an inorganic filler.

5. A metal-based circuit board obtainable by patterning the metal foil included in the circuit board laminate according to claim 3 or 4.

6. A power module comprising the metal-based circuit board according to claim 5.

## Patentansprüche

1. Wärmehärtbare Epoxidharzzusammensetzung, die ein Epoxidharz, eine aromatische Aminverbindung, die durch die nachstehende allgemeine Formel (1) dargestellt wird, einen Bor-Phosphor-Komplex, der durch die nachstehende allgemeine Formel (2) dargestellt wird, und eine Phosphorverbindung, die durch die nachstehende allgemeine Formel (3) dargestellt wird, umfasst, 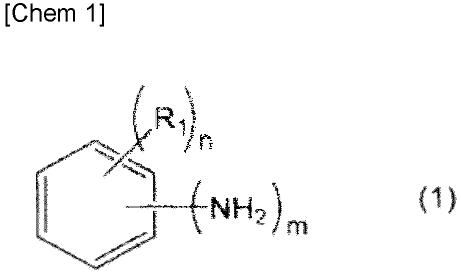
wobei in der allgemeinen Formel (1) R₁ eine Alkylgruppe darstellt, m eine ganze Zahl von 2 oder mehr darstellt, n eine ganze Zahl von 0 oder mehr darstellt, und m und n m + n ≤ 6 erfüllen, und wenn n eine ganze Zahl von 2 oder mehr ist, eine Vielzahl von R₁ gleich oder voneinander verschieden sein kann, 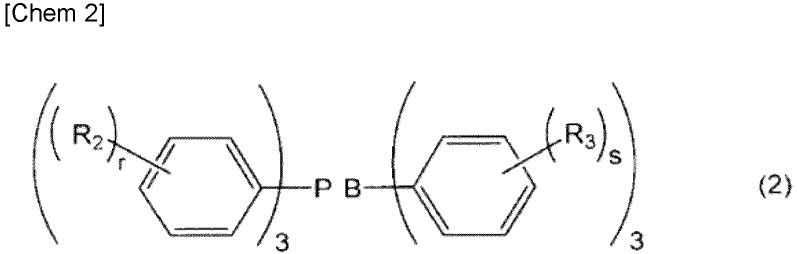
wobei in der allgemeinen Formel (2) R₂ und R₃ jeweils unabhängig voneinander eine Alkylgruppe darstellen, r eine ganze Zahl von 0 oder
mehr und 5 oder weniger darstellt, und s eine ganze Zahl von 0 oder mehr und 5 oder weniger darstellt, wenn r eine ganze Zahl von 2 oder mehr ist, eine Vielzahl von R₂ gleich oder voneinander verschieden sein kann, und wenn s eine ganze Zahl von 2 oder mehr ist, eine Vielzahl von R₃ gleich oder voneinander verschieden sein kann, 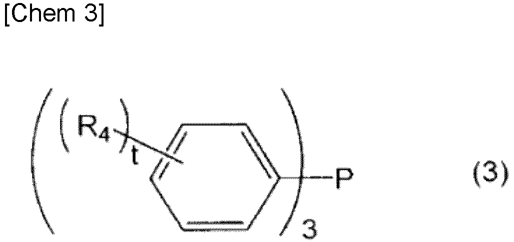
wobei in der allgemeinen Formel (3) R₄ eine Alkylgruppe oder eine Alkoxygruppe darstellt, und t eine ganze Zahl von 0 oder mehr und 5 oder weniger darstellt, und wenn t eine ganze Zahl von 2 oder mehr ist, eine Vielzahl von R₄ gleich oder voneinander verschieden sein kann.

2. Wärmehärtbare Epoxidharzzusammensetzung nach Anspruch 1, die ferner einen anorganischen Füllstoff umfasst.

3. Leiterplattenlaminat, umfassend: ein Metallsubstrat; eine Isolierschicht, die auf mindestens einer Oberfläche des Metallsubstrats vorgesehen ist; und eine Metallfolie, die auf der Isolierschicht vorgesehen ist, wobei die Isolierschicht ein gehärteter Film aus einer wärmehärtbaren Epoxidharzzusammensetzung ist, die ein Epoxidharz und eine aromatische Aminverbindung, die durch die nachstehende allgemeine Formel (1) dargestellt wird, umfasst, 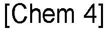 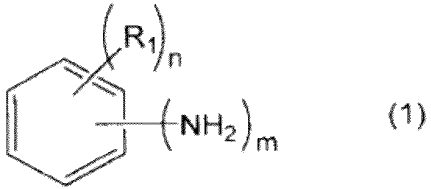
wobei in der allgemeinen Formel (1) R₁ eine Alkylgruppe darstellt, m eine ganze Zahl von 2 oder mehr darstellt, n eine ganze Zahl von 0 oder mehr darstellt, und m und n m + n ≤ 6 erfüllen, und wenn n eine ganze Zahl von 2 oder mehr ist, eine Vielzahl von R₁ gleich oder voneinander verschieden sein kann,
wobei die wärmehärtbare Epoxidharzzusammensetzung ferner einen Bor-Phosphor-Komplex, der durch die nachstehende allgemeine Formel (2) dargestellt wird, und eine Phosphorverbindung, die durch die nachstehende allgemeine Formel (3) dargestellt wird, umfasst, 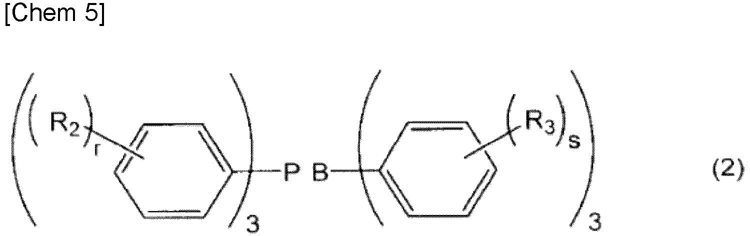
wobei in der allgemeinen Formel (2) R₂ und R₃ jeweils unabhängig voneinander eine Alkylgruppe darstellen, r eine ganze Zahl von 0 oder mehr und 5 oder weniger darstellt, und s eine ganze Zahl von 0 oder mehr und 5 oder weniger darstellt, wenn r eine ganze Zahl von 2 oder mehr ist, eine Vielzahl von R₂ gleich oder voneinander verschieden sein kann, und wenn s eine ganze Zahl von 2 oder mehr ist, eine Vielzahl von R₃ gleich oder voneinander verschieden sein kann, 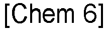 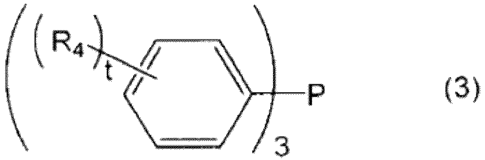
wobei in der allgemeinen Formel (3) R₄ eine Alkylgruppe oder eine Alkoxygruppe darstellt, und t eine ganze Zahl von 0 oder mehr und 5 oder weniger darstellt, und wenn t eine ganze Zahl von 2 oder mehr ist, eine Vielzahl von R₄ gleich oder voneinander verschieden sein kann.

4. Leiterplattenlaminat nach Anspruch 3, wobei die wärmehärtbare Epoxidharzzusammensetzung ferner einen anorganischen Füllstoff umfasst.

5. Metallbasierte Leiterplatte, die durch das Strukturieren der im Leiterplattenlaminat nach Anspruch 3 oder 4 enthaltenen Metallfolie erhalten werden kann.

6. Leistungsmodul, das die metallbasierte Leiterplatte nach Anspruch 5 umfasst.

## Revendications

1. Composition de résine époxy thermodurcissable comprenant une résine époxy, un composé d'amine aromatique représenté par la formule générale (1) ci-dessous, un complexe bore-phosphore représenté par la formule générale (2) ci-dessous, et un composé de phosphore représenté par la formule générale (3) ci-dessous 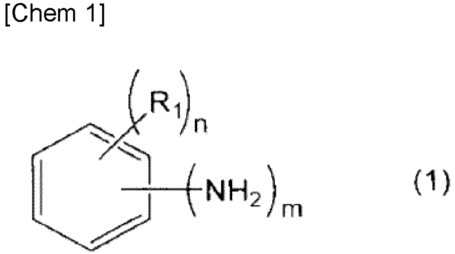
dans lequel, dans la formule générale (1), R₁ représente un groupe alkyle, m représente un entier de 2 ou plus, n représente un entier de 0 ou plus, et m et n satisfont m + n ≤ 6, et lorsque n est un entier de 2 ou plus, une pluralité de R₁ peuvent être identiques ou différents les uns des autres, 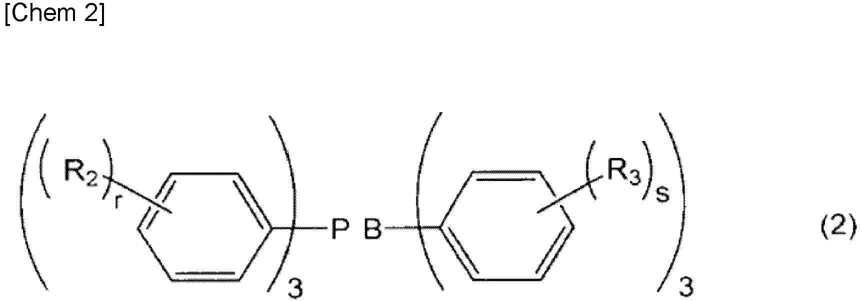
dans lequel, dans la formule générale (2), R₂ et R₃ représentent chacun indépendamment un groupe alkyle, r représente un entier de 0 ou plus et de 5 ou moins, et s représente un entier de 0 ou plus et de 5 ou moins, lorsque r est un entier de 2 ou plus, une pluralité de R₂ peuvent être identiques ou différents les uns des autres, et lorsque s est un entier de 2 ou plus, une pluralité de R₃ peuvent être identiques ou différents les uns des autres, 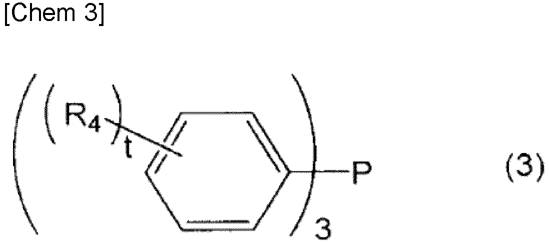
dans lequel, dans la formule générale (3), R₄ représente un groupe alkyle ou un groupe alkoxy, et t représente un entier de 0 ou plus ou de 5 ou moins, et lorsque t est un entier de 2 ou plus, une pluralité de R₄ peuvent être identiques ou différents les uns des autres.

2. Composition de résine époxy thermodurcissable selon la revendication 1, comprenant en outre une charge inorganique.

3. Stratifié de carte de circuit imprimé comprenant : un substrat métallique ; une couche isolante disposée sur au moins une surface du substrat métallique ; et une feuille métallique disposée sur la couche isolante, la couche isolante étant un film polymérisé d'une composition de résine époxy thermodurcissable comprenant une résine époxy et un composé d'amine aromatique représenté par la formule générale (1) ci-dessous 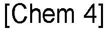 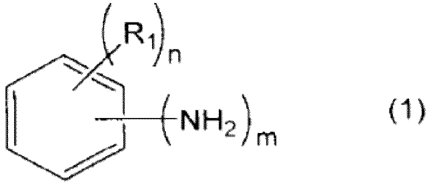
dans lequel, dans la formule générale (1), R₁ représente un groupe alkyle, m représente un entier de 2 ou plus, n représente un entier de 0 ou plus, et m et n satisfont m + n ≤ 6, et lorsque n est un entier de 2 ou plus, une pluralité de R₁ peuvent être identiques ou différents les uns des autres,
dans lequel la composition de résine époxy thermodurcissable comprend en outre un complexe bore-phosphore représenté par la formule générale (2) ci-dessous, et un composé de phosphore représenté par la formule générale (3) ci-dessous, 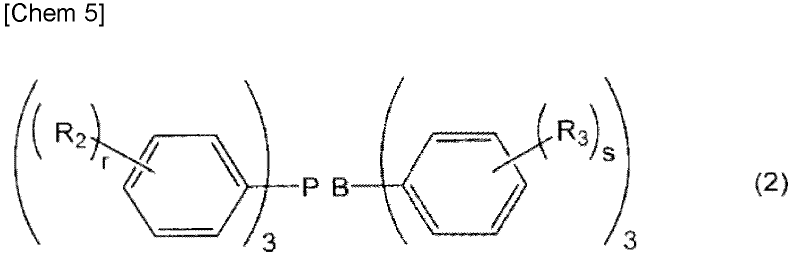
dans lequel, dans la formule générale (2), R₂ et R₃ représentent chacun indépendamment un groupe alkyle, r représente un entier de 0 ou plus et de 5 ou moins, et s représente un entier de 0 ou plus et de 5 ou moins, lorsque r est un entier de 2 ou plus, une pluralité de R₂ peuvent être identiques ou différents les uns des autres, et lorsque s est un entier de 2 ou plus, une pluralité de R₃ peuvent être identiques ou différents les uns des autres, 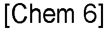 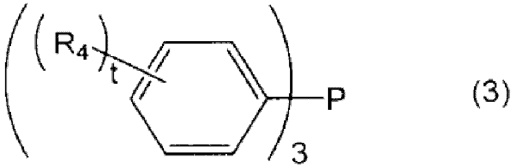
dans lequel, dans la formule générale (3), représente un groupe alkyle ou un groupe alkoxy, et t représente un entier de 0 ou plus ou de 5 ou moins, et lorsque t est un entier de 2 ou plus, une pluralité de R₄ peuvent être identiques ou différents les uns des autres.

4. Stratifié de carte de circuit imprimé selon la revendication 3, dans lequel la composition de résine époxy thermodurcissable comprend en outre une charge inorganique.

5. Carte de circuit imprimé à base de métal, pouvant être obtenue par modelage de la feuille métallique incluse dans le stratifié de carte de circuit imprimé selon la revendication 3 ou 4.

6. Module électrique comprenant la carte de circuit imprimé à base de métal selon la revendication 5.
